# EUROPEAN PATENT APPLICATION

(11) **EP 2 810 950 A1**
(43) Date of publication of application: **10.12.2014**
(21) Application number: 13305748.9
(22) Date of filing: 04.06.2013
(51) Int. Cl.: C07F 9/00, H01L 21/00, H01L 27/00

(54) **Niobium-complexes and their use in a method for forming a niobium-containing layer on a substrate**

(71) Applicant: L'AIR LIQUIDE, SOCIETE ANONYME POUR L'ETUDE ET L'EXPLOITATION DES PROCEDES GEORGES CLAUDE, 75007 Paris (FR)
(72) Inventor: Lachaud, Christophe, 91240 Saint-Michel Sur Orge (FR); Correia - Anacleto, Antony, 94000 Creteil (FR); Lahootun, Vanina, 91270 Vigneux Sur Seine (FR); Zauner, Andreas, 78960 Voisins Le Bretonneux (FR)
(74) Representative: Grout de Beaufort, François-Xavier

(57) **Abstract**

A method for forming a niobium-containing layer on a substrate, the method comprising at least the steps of:
a) providing a vapor comprising at least one precursor compound according to the invention;
b) reacting the vapor comprising the at least one compound according to the invention with the substrate, according to an atomic layer deposition process, to form a layer of a niobium-containing complex on at least one surface of said substrate.

## Description

The invention relates to new compounds and method for forming a niobium-containing layer on a substrate using an ALD (Atomic Layer Deposition) process. New advanced materials are required to meet future microelectronic challenges in large scale production. These materials deposited as thin films must be conformal and uniform in 3D complex architectures. Chemical vapour deposition based methods are the only known viable techniques to achieve such needs. Furthermore, structural and electrical properties are required. The conductive character of thin films is investigated for electrode applications and high dielectric constant values for insulating layers.

First reported TaN depositions by CVD were carried out using halides based precursors. However, many issues appeared. On one hand, high deposition temperatures were required, more than 700°C, to obtain conductive TaN films (∼300 µΩ.cm) from TaCl₅, and on the other hand, the incorporation of halogen impurities prevent the reduction of tantalum from the degree of oxidation +V to +III.

Deposition of TaN thin films using pentakis dimethylamido tantalum [Ta(N(CH₃)₂)₅], PDMAT, with ammonia was achieved. It can be noticed that the film was rich in nitrogen and highly resistive. Besides, the precursor is in a solid state and exhibits poor thermal stability.

Many studies are led on the TaN deposition using [(CH₃)₃CN=Ta(N(Et₂))₃], TBTDET as metal source. It is believed that the double bond between the tantalum and nitrogen atom in the TBTDET is preserved during the deposition process and confers to the metal-organic source higher thermal stability. However, the deposition temperatures are too high for barrier diffusion application. Urdahl & al, in WO02/20870, have also proposed TBTDET for the deposition of Ta₂O₅.

[(Ta(Et-C=C-Et)(NMe₂)₃)] has been recently patented by DuPont de Nemours [US200603071]. This molecule is interesting due to the presence of the hexyne function which does not supply electrons to the metallic center nucleus which allows to tune its degree of oxidation, needed to deposit TaN conductive layers. However, this compound shows poor thermal stability.

Currently, Atomic Layer Deposition is one of the most promising deposition techniques to ensure high quality thin films with a control at the atomic scale. However, a lack of metal-organic sources prevents to tune thin films properties in terms of electrical characteristics and/or thermal stability.

The main interest of this invention is to combine a nitrogen double bond to a Nb based metal-organic precursor with a hexyne function allowing to decrease the degree of oxidation of the metallic nucleus in the deposited material, in order to increase its thermal stability.

According to a first embodiment, the invention relates to compounds:
Nb(Me-C=C-Me)(Cl)(=NtBu)
Nb(Me-C=C-Me)(Cl)(=NiPr)
Nb(Me-C=C-Me)(Cl)(=NMe)
Nb(Me-C=C-Me)(Cl)(=NEt)
Nb(Et-C=C-Et)(Cl)(=NtBu)
Nb(Et-C=C-Et)(Cl)(=NiPr)
Nb(Et-C=C-Et)(Cl)(=NMe)
Nb(Et-C=C-Et)(Cl)(=NEt).

According to another embodiment, the invention relates to a method for forming a niobium-containing layer on a substrate, the method comprising at least the steps of:
a) providing a vapor comprising at least one precursor compound as defined above;
b) reacting the vapor comprising the at least one compound as defined above with the substrate, according to an atomic layer deposition process, to form a layer of a niobium-containing complex on at least one surface of said substrate.

According to another embodiment, the invention relates to a method as defined above further comprising the step:
c) reaction of the complex formed obtained in step b) with a reagent selected from another metal source, reducing reactants and/or nitriding reactants and/or oxidizing reactants.

According to another embodiment, the invention relates to a method as defined above wherein each R¹ are different from one another and each R² are different from one another.

According to another embodiment, the invention relates to a method as defined above wherein the vapour provided in step a) further comprises one or more metal (M')-organic precursor(s) to produce thin films containing niobium and M'.

According to another embodiment, the invention relates to a method as defined above further comprising providing at least one reaction gas wherein the at least one reaction gas is selected from the group consisting of hydrogen, hydrogen sulfide, hydrogen selenide, hydrogen telluride, carbon monoxide, ammonia, organic amine, silane, disilane, higher silanes, silylamines, diborane, hydrazine, methylhydrazine, chlorosilane and chloropolysilane, metal alkyl, arsine, phosphine, trialkylboron, oxygen, ozone, water, hydrogen peroxide, nitrous oxide, nitrogen monoxide, nitrogen dioxide, alcohols, plasma comprising fragments of those species, and combinations thereof, preferably ozone or water.

According to another embodiment, the invention relates to a method as defined above wherein the temperature of the substrate is 150°C to 450°C, preferably 380°C to 425°C.

According to another embodiment, the invention relates to a method as defined above wherein the atomic layer deposition chamber containing the substrate has a pressure of 0.133 Pa to 13 kPa.

According to another embodiment, the invention relates to a method as defined above further comprising the step of purging excess vapor comprising the at least one compound as defined above from the substrate, with an inert gas selected from the group consisting of hydrogen, nitrogen, helium, argon, and mixtures thereof.

According to another embodiment, the invention relates to a method of manufacturing a semiconductor structure, comprising the steps of the method defined above, wherein the substrate is a semiconductor substrate The inventors have concluded from the background of the invention that new Nb metal-organic precursors for the deposition of metal-containing thin films for applications in the semiconductor industry are required.

In particular, new metal-organic precursors are needed for the deposition by vapor phase of pure metal, metal carbide, metal nitride, metal carbo-nitride, metal silicide, metal silico-carbide, metal silico-nitride, metal oxides or metal silico-oxide.

Those films are highly desirable for application in the semiconductor industry either as:
- Copper diffusion barrier in BEOL applications
- CMOS metal gate
- High-k layers in memory devices
- Metal electrodes for Metal-Insulator-Metal applications (DRAM, etc.).

Despite the precursors look very suitable for applications in the semiconductor industry, it is not limited to this industry only. Nb containing layers can be used among other applications to increase wear resistance, catalytic applications, and sensors.

The novel metal-organic compounds have the original characteristic of containing one unsaturated carbonated bond and one alkylimido ligand.

According to the inventors, this novel family of metal-organic compounds has attractive thermal properties. The proposed new metal-organic precursors present the advantages of:
- being thermally stable to enable proper distribution (gas phase or direct liquid injection) without particles generation,
- being thermally stable and reactive to allow wide self-limited ALD window or forbid decomposition in homogeneous gas phase during MOCVD,
- being possible to be dissolved in organic solvents,
- allowing the deposition of Nb containing films, including without limitation binary, ternary and more materials, by using one or a combination of co-reactants.

Co-reactants are selected without limitation among the group consisting of H₂, hydrogen radicals (H.), NH₃, nitrogen (N₂), hydrazine and alkyl derivatives, N-containing radicals (for instance N·, NH·, NH₂·, NRₓ· with R selected among the group of alkyls), amines, O₂, oxygen radicals (for instance O. or OH.), NO, N₂O, NO₂, H₂O₂ H₂O, O₃, SiH₄, Si₂H₆, Si₃H₈, TriDMAS, BDMAS, 3MS, 4MS, BDEAS, TDEAS, TDMAS, TEMAS, (SiH₃)₃N, (SiH₃)₂O, TMA, DMAi, DEAE, Al(NEt₂)₃ or any other element in the group II, III-A, III-B, sulphur (S) based compounds, transition metal, lanthanoids, rare-earth metals, ZyALD, TEMAZ, TDMAZ, TDEAZ, TEMAH, TDMAH, TDEAH.

In one embodiment of the invention, these new metal-organic precursors are preferably liquids at room temperature or with a melting point lower than 100°C, or easily to liquefy for easy handling.

In one embodiment of the invention, these new metal organic precursors exhibit a vapor pressure equal or higher than 133 Pa at 100°C

### Method of depositing Nb metal containing films: Nb, NbC, NbCN, Nb₂O₅, NbOₓN_{y}, NbM'OₓN_{y}

The thin film deposition of Nb based materials using a compound as defined above according to the invention as metal source above described, comprises the steps of:
- Vaporizing the said metal source to obtain the respective gas phase metal source;
- Feeding a plurality of precursors in vapor phase to a deposition furnace, wherein said precursors comprise said vaporized metal source (M' = Si, Al, Zr, Hf and lanthanoids), and may comprise without limitation another metal source, an oxygen source, a nitrogen source, a carbon source; and forming the said metal containing film.

In one embodiment of the invention, the vaporization of the new metal-organic compound is realized by introducing a carrier gas into a heated bubbler containing the said new metal source. The container is preferably heated at a temperature to get the said metal source in liquid phase and at a sufficient vapor pressure. The carrier gas can be selected, without limitation, from Ar, He, H₂, N₂ or mixtures of them. The said metal source can be mixed to a solvent or a mixture of solvent, to another metal source or to a mixture of them in the container. The container can for instance be heated at temperatures in the range of 20-150°C. Those skilled in the art will consider that the temperature of the container can be adjusted to control the amount of vaporized precursor.

In another embodiment of the invention, the said metal source is fed in liquid state to a vaporizer where it is vaporized. The said metal source can be mixed to another metal source. The said mixture of metal sources can be mixed to a solvent or a mixture of solvent. The said metal source can be mixed to a stabilizer. The said solvent can be selected without limitation in the group consisting of alcanes such as hexane, heptane, octane, aromatic solvents such as benzene, toluene, mesitylene, xylene, silicon containing solvent such as hexamethyldisiloxane, hexamethyldisilazane, tetramethylsilane, sulphur containing solvents such as dimethylsulfoxide or oxygen containing solvent such as tetrahydrofuran, dioxane.

The said vaporized metal source is introduced into a reaction chamber where it is contacted to a substrate. The substrate can be selected without limitation in the group consisting of Si, SiOₓ, SiNₓ, SiOₓN_{y}, Cu, GeOₓ. The substrate can be heated to sufficient temperature to obtain the desired film at sufficient growth rate and with desired physical state and composition. Typical temperature ranges from 150 to 600°C. Preferably the temperature is lower or equal to 450°C. The pressure in the reaction chamber is controlled to obtain the desired metal containing film at sufficient growth rate. The typical pressure range is from 0.133 Pa to 13 kPa or higher.

In one embodiment of the invention, the said metal source is mixed to reactant species prior to the reaction chamber.

In another embodiment of the invention, the said metal source and the reactant species are introduced sequentially in the reaction chamber. The said metal source and the reactant species can be introduced simultaneously (Metal Organic Chemical Vapor Deposition) with or without the assistance of a plasma source, sequentially (Atomic Layer Deposition) with or without the assistance of a plasma source or different combinations (one example is to introduce metal source and the other metal source together in one pulse and reactant species in a separate pulse [modified Atomic Layer Deposition]); another example is to introduce the reactant species (one example could be oxygen) continuously and to introduce metal source by pulses (pulsed Chemical Vapor Deposition).

In one embodiment of the invention, the reactant species are passed through a remote plasma system and decomposed to radicals.

In one embodiment of the invention where the targeted metal based film contains oxygen, such as for example without limitation metal oxide or metal oxy-nitride, the said reactant species include an oxygen source which is selected from, but not limited to, oxygen (O₂), oxygen radicals (for instance O· or OH·), for instance generated by a remote plasma system, ozone (O₃), NO, N₂O, NO₂, moisture (H₂O) or H₂O₂.

In one embodiment of the invention where the targeted metal based film contains nitrogen, such as for example without limitation metal nitride or metal carbo-nitride, the said reactant species include a nitrogen source which is selected from, but not limited to, nitrogen (N₂), ammonia, hydrazine and alkyl derivatives, N-containing radicals (for instance N·, NH·, NH₂·), NO, N₂O, NO₂ or amines.

In one embodiment of the invention where the targeted metal based film contains carbon, such as for example without limitation metal carbide or metal carbo-nitride, the said reactant species include a carbon source which is selected from, but not limited to, methane, ethane, propane, butane, isobutane, ethylene, propylene, isobutylene or CCl₄.

In one embodiment of the invention where the targeted metal based film contains silicon, such as for example without limitation metal silicide, silico-nitride, silicate, silico-carbo-nitride, the said reactant species include a silicon source which is selected from, but not limited to, SiH₄, Si₂H₆, Si₃H₈, SAM 24, TriDMAS, BDMAS, BDEAS, TDEAS, TDMAS, 3MS, 4MS, TEMAS, (SiH₃)₃N, (SiH₃)₂O, trisilylamine, disiloxane, trisilylamine, a alkoxysilane SiHₓ(OR¹)₄₋ₓ, a silanol Si(OH)ₓ(OR¹)₄₋ₓ (preferably Si(OH)(OR¹)₃; more preferably Si(OH)(OtBu)₃ an aminosilane SiHₓ(NR¹R²)₄₋ₓ (where x is comprised between 0 and 4; R¹ and R² are independently from H or a C1-C6 carbon chain, either linear, branched or cyclic; preferably TriDMAS SiH(NMe₂)₃, BTBAS SiH₂(NHtBu)₂) ; BDEAS SiH₂(NEt₂)₂) and mixtures thereof. The targeted film can alternatively contain Germanium. The above-mentioned Si containing sources could be replaced by Ge containing sources.

In one embodiment of the invention, the said metal source is mixed to another metal source to deposit a multi-metal containing film where the second metal could be Al, Hf, Zr or lanthanoids. The other metal source can be selected without limitation in the group consisting of TMA, DMAi, DEAE, Al(NEt₂)₃ or any other element in the group II, III-A, III-B, transition metal, lanthanoids, rare-earth metals, ZyALD, TEMAZ, TDMAZ, TDEAZ, TEMAH, TDMAH, TDEAH.

In one embodiment of the invention, the said metal sources are simultaneously introduced and mixed into the reaction chamber. The reactor pressure is selected in the range from 0.133 Pa to 13 kPa or higher. Preferably, the reactor pressure is comprised between 133 Pa and 1332 Pa. The flow rate of the reactants is selected in the range from 0.5mL/min to 1 L/min.

In another embodiment of the invention, the said metal sources are simultaneously introduced and mixed to reactant species into the reaction chamber. The reactor pressure is selected in the range from 0.133 Pa to 13 kPa or higher. Preferably, the reactor pressure is comprised between 133 Pa and 1332 Pa. The flow rate of the reactants is selected in the range from 0.5mL/min to 1 L/min.

In one embodiment of the invention, the said metal-organic compounds are used to deposit metal-containing thin films by Atomic Layer Deposition. The said metal source, a possible second metal source, and the reactant species are introduced sequentially in the reaction chamber (Atomic Layer Deposition). The reactor pressure is selected in the range from 0.133 Pa to 13 kPa or higher. Preferably, the reactor pressure is comprised between 133 Pa and 1332 Pa. A purge gas (or vacuum step) is introduced between the metal source pulse and the reactant species pulse. The purge gas (or vacuum step) can be selected without limitation from the group consisting of N₂, Ar, He. The metal source, purge gas and reactant species pulse duration is independently comprised between 0.1 and 100 s. Preferably, the pulse duration is comprised between 0.5 and 10 s. The flow rate of the reactants is selected in the range from 0.5mL/min to 1 L/min.

### 1. Examples

### A. CVD process using Nb(Et-C=C-Et)(Cl)(=NtBu) and ammonia

Nb(Et-C=C-Et)(Cl)(=NtBu) is stored into a container. The container is heated at 120°C and N₂ is used as carrier gas at a flow of 50 sccm. Ammonia (NH₃) is used as nitrogen source. The substrate is heated at 350°C. The precursor is simultaneously introduced into the reaction chamber with NH₃. A film of niobium nitride is obtained.

### B. ALD process using Nb(Et-C=C-Et)(Cl)(=NtBu) and ammonia

Nb(Et-C=C-Et)(Cl)(=NtBu) is stored into a container. The container is heated at 120°C and N₂ is used as carrier gas at a flow of 50 sccm. Ammonia (NH₃) is used as nitrogen source. The substrate is heated at 350°C. The precursor is sequentially introduced into the reaction chamber with NH₃ during the first step a pulse of Nb(Et-C=C-Et)(Cl)(=NtBu) is introduced during 8 seconds, followed by a 13 seconds N₂ purge. A pulse of NH₃ is then introduced into the reaction chamber during 8 seconds, followed by a 13 seconds N₂ purge. The first step is then done again. 400 cycles are performed this way. A film of niobium nitride is obtained.

### C. CVD process using Nb(Et-C=C-Et)(Cl)(=NtBu)and ozone (O₃)

Nb(Et-C=C-Et)(Cl)(=NtBu) is stored into a container. The container is heated at 120°C and N₂ is used as carrier gas at a flow of 50 sccm. Ozone (O₃) is used as oxygen source. The substrate is heated at 325°C. The precursor is simultaneously introduced into the reaction chamber with ozone (O₃). A film of niobium oxide is obtained.

## Claims

1. Compounds:
Nb(Me-C=C-Me)(Cl)(=NtBu)
Nb(Me-C=C-Me)(Cl)(=NiPr)
Nb(Me-C=C-Me)(Cl)(=NMe)
Nb(Me-C=C-Me)(Cl)(=NEt)
Nb(Et-C=C-Et)(Cl)(=NtBu)
Nb(Et-C=C-Et)(Cl)(=NiPr)
Nb(Et-C=C-Et)(Cl)(=NMe)
Nb(Et-C=C-Et)(Cl)(=NEt).

2. A method for forming a niobium-containing layer on a substrate, the method comprising at least the steps of:
a) providing a vapor comprising at least one precursor compound as defined in Claim 1;
b) reacting the vapor comprising the at least one compound of Claim 1 with the substrate, according to an atomic layer deposition process, to form a layer of a niobium-containing complex on at least one surface of said substrate.

3. The method of claim 2 further comprising the step:
c) reaction of the complex formed obtained in step b) with a reagent selected from another metal source, reducing reactants and/or nitriding reactants and/or oxidizing reactants.

4. The method of any one of claims 2 to 3, wherein the vapour provided in step a) further comprises one or more metal (M')-organic precursor(s) to produce thin films containing niobium and M'.

5. The method of any one of claims 2 to 4, further comprising providing at least one reaction gas wherein the at least one reaction gas is selected from the group consisting of hydrogen, hydrogen sulfide, hydrogen selenide, hydrogen telluride, carbon monoxide, ammonia, organic amine, silane, disilane, higher silanes, silylamines, diborane, hydrazine, methylhydrazine, chlorosilane and chloropolysilane, metal alkyl, arsine, phosphine, trialkylboron, oxygen, ozone, water, hydrogen peroxide, nitrous oxide, nitrogen monoxide, nitrogen dioxide, alcohols, plasma comprising fragments of those species, and combinations thereof, preferably ozone or water.

6. The method of any one of claims 2 to 5, wherein the temperature of the substrate is 150°C to 450°C, preferably 380°C to 425°C.

7. The method of claim 6, wherein the atomic layer deposition chamber containing the substrate has a pressure of 0.133 Pa to 13 kPa.

8. The method of any one of claims 2 to 7, further comprising the step of purging excess vapor comprising the at least one compound of Claim 1 from the substrate, with an inert gas selected from the group consisting of hydrogen, nitrogen, helium, argon, and mixtures thereof.

9. A method of manufacturing a semiconductor structure, comprising the steps of the method defined in any one of claims 2 to 8, wherein the substrate is a semiconductor substrate.
